(19) Europäisches Patentamt

European Patent Office

Office européen des brevets

(11) EP 0 624 943 B1

(12) FASCICULE DE BREVET EUROPEEN

(45) Date de publication et mention
de la délivrance du brevet:
02.08.2000 Bulletin 2000/31

(51) Int. Cl.⁷: **H02H 9/02**, H01L 29/86, H01L 27/02

(21) Numéro de dépôt: 94410032.0

(22) Date de dépôt: 09.05.1994

(54) **Composant limiteur de courant série**

Seriengeschaltetes Strombegrenzerbauelement

Serial current limiting device

(84) Etats contractants désignés:
**DE FR GB IT**

(30) Priorité: **10.05.1993 FR 9305886**

(43) Date de publication de la demande:
**17.11.1994 Bulletin 1994/46**

(73) Titulaire:
**STMicroelectronics S.A.**
**94250 Gentilly (FR)**

(72) Inventeurs:
• **Ayela, Christophe**
**F-37000 Tours (FR)**
• **Leturco, Philippe**
**F-31650 Auzielle (FR)**
• **Jalade, Jean**
**F-31320 Castanet Tolasan (FR)**
• **Sanchez, Jean-Louis**
**F-31750 Escalquens (FR)**

(74) Mandataire: **de Beaumont, Michel**
**1bis, rue Champollion**
**38000 Grenoble (FR)**

(56) Documents cités:
EP-A- 0 318 404          EP-A- 0 543 742
FR-A- 2 412 166          FR-A- 2 641 417
US-A- 3 603 811          US-A- 5 055 895

• ELECTRONIC DESIGN, vol.24, no.12, 7 Juin
1976, HASBROUCK HEIGHTS, NEW JERSEY US
page 160 M. GRAYEFF ET AL. 'FETS PROVIDE
CURRENT LIMITING FOR PROTECTION
AGAINST SHORTS'
• PATENT ABSTRACTS OF JAPAN vol. 7, no. 204
(E-197) (1349) 9 Septembre 1983 & JP-A-58 100
460 (HITACHI) 15 Juin 1983
• PATENT ABSTRACTS OF JAPAN vol. 10, no. 332
(E-453) (2388) 12 Novembre 1986 & JP-A-61 137
368 (HITACHI) 25 Juin 1986
• PATENT ABSTRACTS OF JAPAN vol. 14, no. 362
(E-960) 6 Août 1990 & JP-A-02 128 474 (NEC) 16
Mai 1990

**Description**

La présente invention concerne un circuit limiteur de courant.

On utilise généralement deux types de circuits de protection contre des surintensités dans une charge. Le mode de protection le plus courant consiste à disposer un circuit de limitation de tension à écrêtage ou à retournement en parallèle sur la charge. Toutefois, dans certains cas, des circuits série sont souhaitables. Ces circuits sont peu usuels car, quand ils sont réalisés sous forme de composants semiconducteurs, ils nécessitent généralement une détection de courant ou de tension et une commande. Il s'agit donc de dispositifs munis d'une borne de commande qui doivent être associés à des circuits de commande plus ou moins complexes. Par ailleurs, comme composants série de type dipôle, on utilise essentiellement des fusibles ou des varistances. Les fusibles présentent l'inconvénient de devoir être réamorcés après une surcharge. Les varistances sont actuellement des composants coûteux dont le seuil n'est pas toujours déterminé avec précision et dépend de l'environnement (en particulier de la température). De plus, une varistance présente inévitablement une inertie thermique et, par exemple, n'assure pas de protection contre des surintensités rapprochées.

On a également proposé d'utiliser des transistors MOS à déplétion comme limiteurs de courant, la première borne du limiteur étant constituée par une interconnexion des bornes de grille et de source du transistor et la deuxième borne du limiteur étant constituée par la borne de drain du transistor. Cette approche est par exemple rappelée dans le brevet des Etats-Unis d'Amérique 3 603 811 déposé le 9 décembre 1969. Mais ce brevet cite cette approche uniquement pour en faire ressortir les inconvénients.

La présente invention vise plus particulièrement un composant de protection série destiné à une protection non pas contre un court-circuit dans une charge mais contre des surintensités temporaires, par exemple des surintensités qui se produisent lors de l'allumage d'un tube fluorescent. On vise également le cas où le seuil de protection peut être compris dans une très large gamme, par exemple entre quelques dizaines de milliampères et plusieurs ampères.

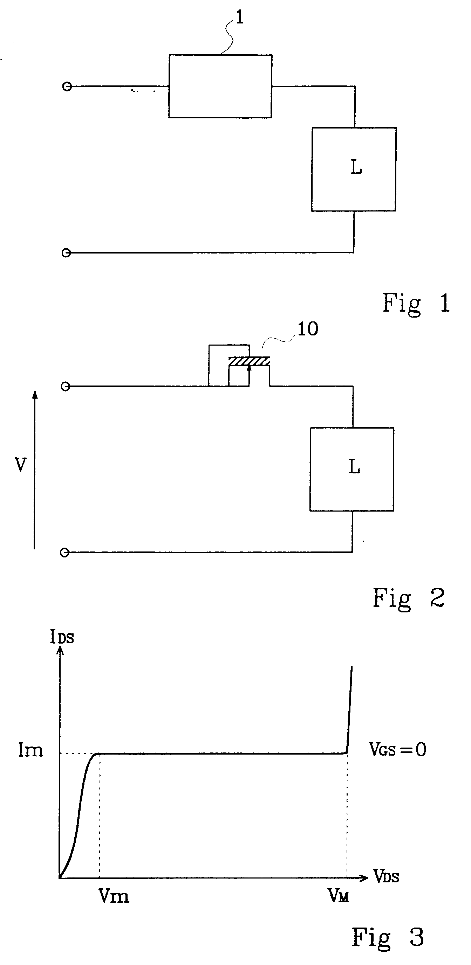

Le schéma normal d'un circuit de limitation de courant dans une charge est illustré en figure 1, il consiste simplement à placer en série avec une charge L un composant limiteur de courant 1. On souhaite également bien entendu que, dans le cas où le courant dans la charge L a une valeur normale, ce composant de limitation de courant présente une impédance aussi faible que possible.

Un objet de la présente invention est de prévoir un limiteur de courant simple et peu coûteux.

Un autre objet de la présente invention est de prévoir un tel limiteur de courant dont le courant de limitation dépend peu de la température.

Un autre objet de la présente invention est de prévoir un tel limiteur de courant de type bidirectionnel.

Pour atteindre ces objets, la présente invention prévoit d'utiliser un transistor MOS ou IGBT vertical à déplétion dans lequel les électrodes de grille et de source sont constituées d'une seule et même métallisation en tant que dispositif de limitation de courant série.

Plus particulièrement, la présente invention prévoit un composant dipôle limiteur de courant tel que défini en revendication 1.

Des modes de réalisation de ce composant sont explicités dans les sous-revendications.

La présente invention vise également un procédé de fabrication du composant dipôle susmentionné.

Plus généralement, la présente invention vise un circuit électronique comprenant en série avec une source éventuelle de surintensités un transistor MOS ou IGBT vertical à déplétion à source et grille interconnectées.

Ces objets, caractéristiques et avantages ainsi que d'autres de la présente invention seront exposés en détail dans la description suivante d'un mode de réalisation particulier faite en relation avec les figures jointes parmi lesquelles :

la figure 1, décrite précédemment, illustre le montage classique d'un composant de limitation de courant série ;

la figure 2 représente un circuit comprenant un composant de limitation de courant du type transistor MOS à déplétion ;

la figure 3 représente la caractéristique courant-tension d'un composant du type transistor MOS à déplétion ;

les figures 4A à 4I représentent des vues en coupe partielle d'un composant selon la présente invention à divers stades de fabrication ;

la figure 5 représente une vue de dessus partielle d'un composant selon la présente invention ;

la figure 6 est une vue en coupe schématique d'un limiteur de courant selon la présente invention à fonctionnement bidirectionnel ;

la figure 7 représente un exemple d'application d'un composant selon la présente invention ; et

la figure 8 représente des chronogrammes de courant utiles à l'explication du fonctionnement du circuit de la figure 7.

Comme cela est usuel dans le domaine de la représentation des composants semiconducteurs, les diverses vues ne sont pas à l'échelle et, en particulier dans les vues en coupe, les épaisseurs des diverses couches ont été tracées arbitrairement pour faciliter la représentation. De même, dans les vues en coupe, les formes des zones diffusées sont fortement schématiques.

La figure 2 représente un circuit incluant une charge L et un composant limiteur de courant 10. Le composant 10 est simplement un transistor MOS à déplétion ayant sa grille reliée à sa source.

Un transistor MOS à déplétion est un composant connu dont la caractéristique de courant drain-source en fonction de la tension drain-source est illustrée en figure 3. Toutefois, dans les montages classiques, ce composant est utilisé comme tripôle, la borne de grille étant utilisée pour commuter ce transistor de l'état passant à l'état bloqué. Quand on regarde la caractéristique de la figure 3, qui correspond à une tension grille-source nulle, c'est-à-dire à une connexion entre la grille et la source, le composant 10 satisfait parfaitement à la fonction de limitation de courant. Tant que le courant qui le traverse reste inférieur à une valeur Im, la chute de tension à ses bornes reste inférieure à une valeur Vm faible, c'est-à-dire que la résistance du composant reste faible. Par contre, si la tension V aux bornes du circuit de la figure 2 augmente de sorte que le courant dans la charge aurait tendanoe à dépasser la valeur Im, ce courant est maintenu à cette valeur par le composant dont la tension aux bornes croît en conséquence. L'excès d'énergie sera donc absorbé par le composant 10. Bien entendu, il convient que la tension aux bornes du composant ne dépasse pas une valeur correspondant à une tension d'avalanche VM. En effet, si la tension aux bornes du composant dépasse cette valeur VM, le courant qui le traverse commence à croître à nouveau et le composant entre dans un mode d'avalanche susceptible d'être destructif.

Ainsi, le composant selon l'invention est adapté à fonctionner comme limiteur de courant dans des applications où la charge L est susceptible de recevoir, ou de produire, des surcharges temporelles, surcharges qui sont absorbées par le composant 10. C'est par exemple le cas, comme cela a été indiqué précédemment, d'un circuit de ballast de lampe fluorescente qui tend à produire des surintensités à l'allumage.

Même dans ce cas, il faut pouvoir évacuer rapidement la chaleur générée dans le composant et assurer que le courant de limitation reste sensiblement constant avec la température. Ceci n'est pas possible quand on utilise un transistor MOS à trois électrodes connectées de façon externe.

Ainsi, la présente invention vise une réalisation d'un limiteur de courant qui va d'abord être décrite en relation avec un exemple de procédé de fabrication particulier illustré en figures 4A à 4I.

Comme le représente la figure 4A, le composant selon la présente invention est formé à partir d'une tranche de silicium comprenant une couche 11 faiblement dopée formée sur un substrat 12 plus fortement dopé du même type de conductivité, ici une couche épitaxiée N sur un substrat N$^+$. La face supérieure de la couche 11 est revêtue d'une couche isolante, classiquement une couche d'oxyde 14, ayant par exemple une épaisseur d'un micromètre dans laquelle sont ouvertes des fenêtres 15. Ensuite, la surface supérieure est soumise à une implantation ionique de dopants propres à conférer aux zones implantées du substrat le type de conductivité P avec un fort niveau de dopage (P$^+$). Cette implantation est désignée par les flèches 16 et correspond par exemple à une implantation de bore de quelques 10$^{15}$ at./cm$^2$ sous 50 keV. Bien entendu, l'épaisseur de la couche d'oxyde 14 (environ 1 micromètre) est suffisante pour protéger les parties sous-jacentes de la couche 11 des effets de l'implantation.

Dans une étape suivante, illustrée en figure 4B, une nouvelle étape de masquage et de photolithographie est réalisée pour élargir les fenêtres 15 et une implantation de type P désignée par les flèches 17 est réalisée. Cette implantation de type P est similaire à l'implantation de type P+ de la figure 4A mais à une plus faible dose et correspond par exemple à une implantation de bore de quelques 10$^{14}$ at./cm$^2$ sous 50 keV.

A l'étape de la figure 4C, on ouvre à nouveau la couche d'oxyde 14 vers la périphérie du composant, on procède à une oxydation de préimplantation pour former une mince couche d'oxyde 20, ayant par exemple une épaisseur de l'ordre de 0,03 à 0,05 μm, et on réalise une implantation de type P$^-$, c'est-à-dire identique à celle des figures 4A et 4B mais avec une plus faible dose, comme cela est indiqué par les flèches 18, qui correspond par exemple à une implantation de bore de quelques 10$^{12}$ at./cm$^2$ sous 50 keV.

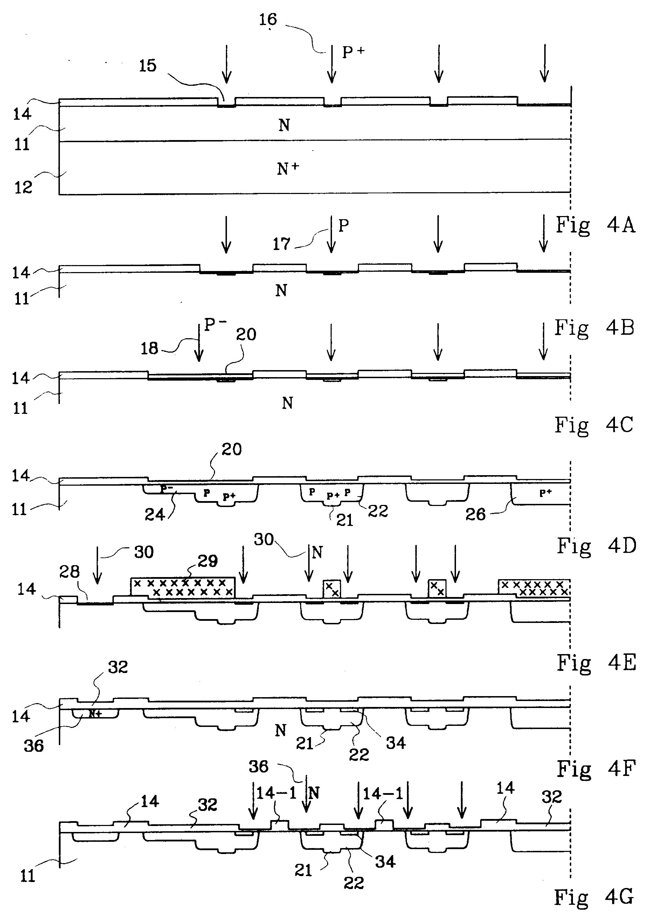

A l'étape suivante illustrée en figure 4D, on procède à un recuit en atmosphère neutre pour faire diffuser les dopants implantés. On obtient ainsi des caissons de type P séparés les uns des autres et comprenant une région centrale 21 de type P$^+$ fortement dopée et une région périphérique 22 de type P plus faiblement dopée. Ces régions ont par exemple des niveaux de dopage respectifs en surface de 10$^{19}$ at./cm$^3$ et 10$^{17}$ at./cm$^3$. On a également représenté une région de type P$^-$ 24 correspondant à l'implantation de la figure 4C. Cette région s'étend comme on le verra ci-après à la périphérie du dispositif et est destinée à assurer l'étalement des lignes de champ et la tenue en tension du dispositif. On peut aussi prévoir une région centrale de type P$^+$ 26 pouvant servir comme cela sera indiqué ci-après à une reprise de contact.

A l'étape suivante, illustrée en figure 4E, on ouvre dans la couche d'oxyde 14 une fenêtre 28 disposée à la périphérie du composant et l'on forme un masque de résine photorésistante 29 qui recouvre la couche d'oxyde mince formée au cours de l'étape de la figure 4C pour laisser apparente cette couche d'oxyde mince dans des zones annulaires disposées à la périphérie interne de chacun des caissons 21-22. On procède ensuite à une implantation d'un dopant de type N à forte dose comme cela est indiqué par les flèches 30. Cette implantation est réalisée directement

3

dans le substrat dans la zone 28 et à travers la couche mince d'oxyde 20 dans les zones périphériques de chacun des caissons 21-22.

A l'étape suivante, illustrée en figure 4F, on procède à un recuit en atmosphère oxydante d'où il résulte que la couche d'oxyde 14 s'épaissit et qu'une nouvelle couche d'oxyde 32 se forme au-dessus des régions dénudées ou recouvertes de la couche d'oxyde très mince 20. Cette réoxydation peut être poursuivie jusqu'à atteindre une épaisseur d'oxyde de l'ordre du micromètre pour la couche 32, l'épaississement de la couche d'oxyde 14 l'amenant alors à une épaisseur de l'ordre de 1,5 µm. On obtient alors la structure illustrée en figure 4F dans laquelle on peut voir, à la surface supérieure de chacun des caissons 21-22, une région annulaire de type N$^+$ 34 (la figure 4F est extrêmement schématique ; en particulier on notera que, pendant la diffusion de la région 34, une diffusion du caisson 21-22 se produit également et que le caisson s'agrandit).

On notera que la limite extérieure de chacune des régions annulaires 34 est déterminée par le masque délimité à la figure 4B qui a également servi à délimiter la périphérie extérieure de chacun des caissons 22. Il y a donc bien auto-alignement de la périphérie extérieure de la région annulaire 34 et de la périphérie extérieure du caisson 22. La distance entre ces périphéries extérieures, qui correspond à la région de canal d'un transistor MOS, est donc déterminée avec précision par auto-alignement.

Par ailleurs, l'implantation N$^+$ formée dans la fenêtre 28 de la figure 4E entraine la formation d'une région périphérique de type N$^+$ 36 qui a la fonction classique d'arrêt de canal.

A la fin de l'étape illustrée en figure 4F, on a formé une structure correspondant à la structure semiconductrice d'un transistor MOS vertical double diffusé. Ce transistor est du type normalement bloqué. Comme on l'a indiqué précédemment, la présente invention vise à former un transistor MOS normalement passant, couramment appelé également transistor MOS à déplétion ou transistor MOS à appauvrissement. Pour cela, il faut inverser le type de conductivité de la région superficielle périphérique de chacun des caissons 22. Ceci est réalisé de la façon illustrée en figure 4G en ouvrant la couche d'oxyde 14-32 au-dessus de chacune des régions des caissons 22 externe aux régions annulaires 34. De préférence, on laisse en place des régions d'oxyde 14-1 au milieu des parties du substrat séparant des caissons voisins et on fait croître une couche très mince d'oxyde de préimplantation 35. On procède alors à une implantation d'un dopant de type N comme cela est indiqué par les flèches 36.

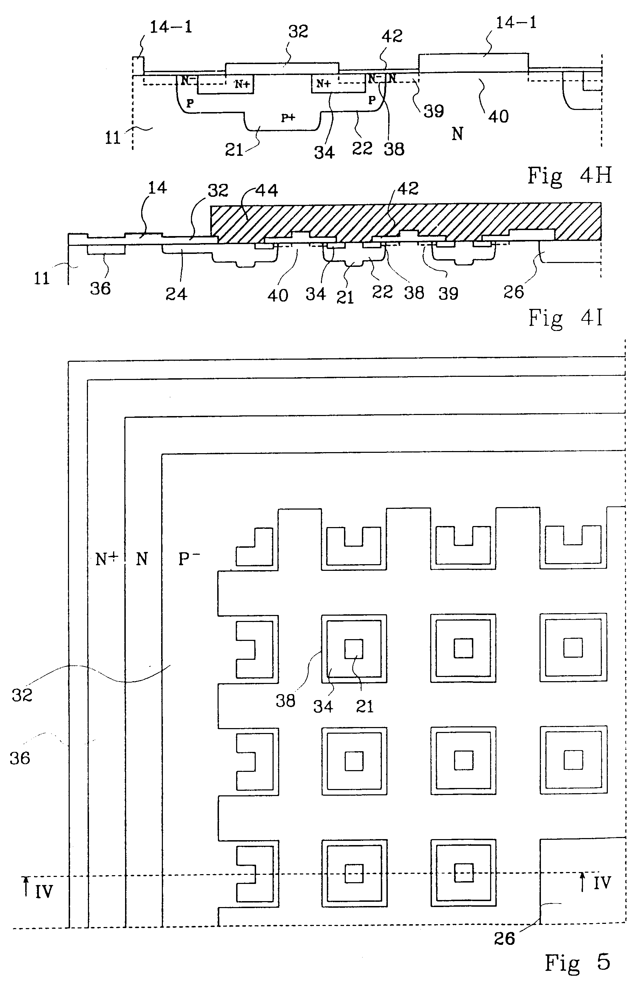

La figure 4H montre la structure obtenue après un recuit de redistribution suivi d'une réoxydation. La figure 4H représente une partie agrandie des figures précédentes au voisinage d'une cellule de transistor MOS. Cette cellule comprend le caisson 21-22 de type P, la région annulaire 34 de type N$^+$ et une région N$^-$ 38 à la surface de la région de canal comprise entre la périphérie de l'anneau 34 et la périphérie du caisson 22. Cette région N$^-$ 38 résulte de l'implantation 36 qui a été effectuée selon une dose suffisante pour inverser le type de conductivité de la région 22 et lui conférer un dopage de niveau désiré pour atteindre la valeur de courant de limitation Im souhaitée.

En effet, le courant de limitation Im est donné par la relation suivante :

$$Im = \mu_n C_{ox}(Z/L)(V_T)^2/2 \qquad (1)$$

où

$\mu_n$      désigne la mobilité des électrons,
$C_{ox}$      désigne la capacité par unité de surface de la couche d'oxyde de grille 42,
$Z$      désigne la largeur de canal,
$L$      désigne la longeur de canal,
$V_T$      désigne la tension de seuil de déplétion du transistor MOS et est directement liée au niveau de dopage de la région de canal 38.

Par exemple, si la concentration de surface de la région 22 était de $10^{16}$ à $10^{17}$ atomes/cm$^3$, l'implantation 36 est réalisée de façon à conférer à la région 38 un dopage de type N d'environ 3 $10^{16}$ à 5 $10^{17}$ atomes/cm$^3$.

L'implantation de déplétion de type N déborde dans la région annulaire 34 mais ne change pratiquement pas son niveau de dopage qui était déjà de l'ordre de $10^{20}$ at./cm$^3$. Par contre, cette région déborde également dans la partie superficielle de la couche épitaxiée 11 et augmente le dopage de cette couche épitaxiée à la valeur sus-indiquée alors que normalement cette couche épitaxiée a un dopage faible de l'ordre de $10^{15}$ at./cm$^3$. Cette région surdopée est désignée par la référence 39 et il demeure sous les parties restantes 14-1 de la couche d'oxyde 14, des régions 40 dans lesquelles le niveau de dopage de la couche épitaxiée reste non modifié. Cette disposition est préférée pour améliorer la tenue en tension du composant qui va être obtenu.

Après les étapes d'implantation et de redistribution, on procède à une oxydation pour développer au-dessus de la région de canal 38 une oouche d'oxyde 42 (épaississement de la couche 35) dans des conditions telles que cette couche 42 ait une épaisseur d'isolement de grille choisie.

Une étape finale de fabrication est illustrée en figure 4I. Un masquage est réalisé pour ouvrir les couches d'oxyde 14, 32, 42 au-dessus des régions centrales de chacune des cellules, pour découvrir la surface supérieure de la région P$^+$ 21 et une partie interne des anneaux N$^+$ 34. Après quoi, une métallisation 44 est formée (éventuellement par une accumulation de plusieurs couches conductrices). Une métallisation similaire non représentée est formée sur la face arrière du composant. On obtient ainsi directement un composant dipôle présentant une métallisation de face avant et une métallisation de face arrière, correspondant à un transistor MOS vertical double diffusé normalement conducteur (à déplétion) dans lequel une seule et même métallisation sert à la fois de métallisation de source et de métallisation de grille.

Un avantage important de cette structure dont les deux faces sont métallisées est qu'elle permet de monter le composant selon l'invention, par exemple par brasage, entre deux plaques conductrices servant de répartiteurs thermiques.

Grâce à ce montage entre plaques de répartiteurs thermiques qui peuvent elles-mêmes être associées à des radiateurs, on limite les montées en températures du composant, on peut donc assurer une stabilité de ses caractéristiques et l'utiliser dans des circuits de puissance relativement élevée.

Selon un aspect de la présente invention, on prévoit de doser le niveau de dopage du canal déplété 38 pour assurer une constance ou une décroissance du courant Im quand la température croît. En effet, par dérivation de la relation (1) et division par Im, en tenant compte de ce que $C_{ox}$, Z et L dépendant peu de la température, on obtient :

$$\frac{dIm}{dT} \cdot \frac{1}{Im} = \frac{d\mu n}{dT} \cdot \frac{1}{\mu n} + 2\frac{dV_T}{dT} \cdot \frac{1}{V_T}, \qquad (2)$$

où T désigne la température.

Il se trouve que $d\mu n/dT$ est négatif et que $dV_T/dT$ est positif.

Pour une variation de température donnée, par exemple pour une température variant entre 300 et 400 K ou entre 300 et 450 K, $d\mu n/\mu n$ a une valeur sensiblement indépendante des caractéristiques propres du composant tandis que $dV_T/V_T$ dépend de $V_T$, c'est-à-dire essentiellement du niveau de dopage du canal 38. Comme le montre le tableau ci-dessous, on choisira ce niveau de dopage pour que $V_T$ soit compris entre 4 et 6 V de sorte que $2dV_T/V_T$ soit sensiblement égal ou inférieur en valeur absolue à $d\mu n/\mu n$.

|  | T = 300-400 K | T = 300-450 K |
|---|---|---|
| $d\mu n/\mu n$ | -0,35 | -0,45 |
| $2dV_T/V_T$ ($V_T$=2 V) | 0,60 | 0,90 |
| $2dV_T/V_T$ ($V_T$=4 V) | 0,30 | 0,45 |
| $2dV_T/V_T$ ($V_T$=6 V) | 0,20 | 0,30 |

En effet, on peut souhaiter avoir une valeur de Im qui diminue quand la température augmente, ce qui crée une autoprotection du composant.

La figure 5 représente une vue de dessus de ce composant dont la figure 4I représente une vue en coupe selon les lignes IV-IV. Cette vue de dessus ne représente pas les couches d'oxyde et la métallisation. On y voit à la périphérie la région N$^+$ d'arrêt de canal 36, la région 32 d'étalement des lignes de champ de type P$^-$, puis les diverses cellules. Dans cette figure canine dans la précédente, on a représenté une région centrale 26 qui peut être utilisée pour établir une connexion. Néanmoins, la réalisation de cette région est optionnelle, et ne sera pas utilisée notamment dans le cas où l'on monte le composant selon l'invention entre deux répartiteurs thermiques. De même, la prévision de régions 40 à dopage de substrat non modifié entre cellules (figures 4H et 4I) n'est pas indispensable et ne sera réalisée que dans le cas où l'on souhaite améliorer la tenue en tension du composant. Chacune des cellules représentées en figure 5 peut avoir une dimension de 50 x 50 µm et la distance entre cellules peut également être de l'ordre de 50 µm.

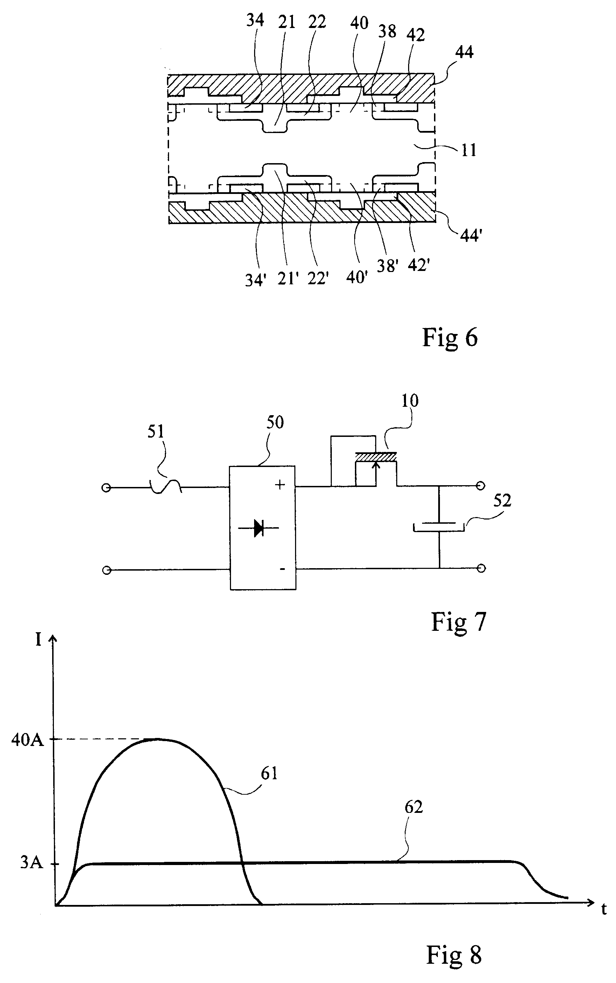

La figure 6 représente une vue en coupe schématique d'un limiteur de courant bidirectionnel selon la présente invention. Dans cette figure, le côté supérieur du substrat est semblable à celui illustré en figure 4I et les diverses régions et couches y sont désignées par les mêmes références. De plus, il est formé symétriquement à partir de la face supérieure du substrat, des mêmes régions et couches qui sont désignées par les mêmes références primées. On obtient ainsi un dipole limiteur de courant bidirectionnel qui fonctionne dans chacune des polarités comme un composant IGBT (voir dernier paragraphe de la présente description).

La figure 7 représente un exemple d'utilisation d'un composant de limitation de courant selon la présente invention. Dans le schéma représenté, un pont redresseur 50 est alimenté par une source de tension alternative, par exemple à 220 volts, un fusible 51 étant prévu dans le circuit alternatif. Les bornes continues du pont redresseur 50 sont reliées par un circuit d'utilisation en parallèle duquel se trouve un condensateur 52. Le circuit de limitation de courant selon l'invention est disposé entre la borne + du pont redresseur et la borne positive du condensateur 52.

Comme le représentent les courbes de la figure 8, normalement, à la mise sous tension, le courant aux bornes du condensateur devrait suivre la courbe 61, c'est-à-dire qu'il augmente rapidement jusqu'à une valeur de l'ordre de 40 ampères avant de chuter quand le condensateur 52 s'est chargé. En utilisant le composant 10 selon la présente invention, présentant par exemple un courant Im de l'ordre de 3 ampères, on obtient une charge régulée selon la courbe 62 et l'on évite un fort appel de courant à l'origine. Dans cette application, le composant 10 voit initialement entre ses bornes pratiquement toute la tension du côté continu du pont redresseur 50, c'est-à-dire que ce composant doit être prévu pour supporter une tension à ses bornes supérieure à 300 volts. On choisira par exemple pour ce composant une valeur VM (voir figure 3) d'environ 400 volts.

On notera deux caractéristiques particulières du composant selon la présente invention, à savoir :

- un auto-alignement des masques définissant la longueur du canal sur une couche d'oxyde épais alors que dans un transistor MOS classique, les masques d'auto-alignement sont réalisés à partir d'une métallisation de grille ("métallisation" qui est éventuellement un niveau de silicium polycristallin),
- l'utilisation d'une seule métallisation de grille et de source alors que, dans un transistor MOS classique, deux métallisations distinctes sont utilisées même si le transistor est utilisé dans un montage à grille et source interconnectées.

Bien entendu, la présente invention est susceptible de nombreuses variantes qui apparaîtront à l'homme de métier, notamment en ce qui concerne la nature des dopants utilisés et des matériaux de métallisation. De même, les niveaux de dopage, les dimensions des cellules et de l'ensemble du composant seront choisis en fonction des performances visées. L'homme de l'art sélectionnera également le type de boîtier à utiliser en fonction des caractéristiques de dissipation thermique visées.

Par ailleurs, dans toute la description qui précède, le composant 10 selon la présente invention a été décrit comme un transistor MOS de type VDMOS à grille et source connectées. Comme cela est connu, un transistor de type IGBT, c'est-à-dire un composant identique dans sa structure à un transistor MOS vertical mais dont la face arrière est fortement dopée de type opposé à celui du substrat, obtenu par exemple à partir d'une épitaxie N sur un substrat $P^+$, présente des caractéristiques de fonctionnement similaires à celles d'un transistor MOS vertical. Si les différents niveaux de dopage ainsi que les dimensions de la cellule sont optimisés, on a une caractéristique courant-tension pour un IGBT très proche de celle obtenue pour un VDMOS mais avec une résistance en fonctionnement normal réduite. Ceci est particulièrement appréciable dans le cas de dispositifs haute tension où la résistance de la couche épitaxiée impose une résistance à l'état passant (pour des valeurs inférieures à la valeur Vm indiquée en figure 3) non négligeable.

**Revendications**

1. Composant dipôle limiteur de courant constitué d'un transistor MOS ou IGBT à déplétion du type vertical double diffusé (VDMOS), caractérisé en ce que la métallisation de source et la métallisation de grille de ce transistor sont constituées d'une seule et même métallisation, et en ce que le niveau de dopage de la région de canal déplété est sélectionné pour que le courant de limitation présente une valeur sensiblement constante en fonction de la température.

2. Composant dipôle limiteur de courant selon la revendication 1, comprenant :

   un substrat (11) d'un premier type de conductivité ;
   des caissons disjoints (21, 22) du deuxième type de conductivité formés dans la surface supérieure du substrat ;
   une première région annulaire (34) du premier type de conductivité à fort niveau de dopage dans chaque caisson ;
   une deuxième région annulaire (38) constituant un canal du premier type de conductivité à faible niveau de dopage et de faible profondeur entre la périphérie externe de chaque première région annulaire et la périphérie de chaque caisson ;
   une couche isolante (42) sur la deuxième région annulaire, la portion de la première région annulaire adjacente à la deuxième région annulaire et les affleurements du substrat entre les caissons et constituant un isolant de grille ;

une première métallisation (44) revêtant la surface supérieure du composant et constituant ladite métallisation de grille et de source ; et

une deuxième métallisation recouvrant la surface inférieure du composant.

3. Composant dipôle selon la revendication 2, caractérisé en ce qu'il comprend en outre une première région périphérique (36) du premier type de conductivité à fort niveau de dopage et une deuxième région périphérique interne (24), séparée de la première région périphérique par une zone du substrat, cette deuxième région périphérique étant du deuxième type de conductivité à faible niveau de dopage.

4. Composant dipôle selon la revendication 2, caractérisé en ce qu'il comprend une région centrale (26) du deuxième type de conductivité à fort niveau de dopage.

5. Composant dipôle selon la revendication 2, caractérisé en ce que la région centrale (21) de chacun des caissons disjoints est plus fortement dopée que la partie périphérique (22).

6. Composant dipôle selon l'une quelconque des revendications 2 à 5, caractérisé en ce qu'il comprend du côté de la face arrière du substrat les mêmes caissons, régions, et couche, d'où il résulte qu'il constitue un limiteur de courant bidirectionnel.

7. Composant dipôle selon l'une quelconque des revendications 1 à 6, caractérisé en ce qu'il est brasé entre deux répartiteurs thermiques.

8. Procédé de fabrication d'un composant dipôle selon la revendication 1, caractérisé en ce que la région de canal résulte d'une implantation du premier type de conductivité formée dans une région périphérique du deuxième type de conductivité de sorte que le niveau de dopage de la région de canal résultante est du premier type de conductivité et telle que le courant de limitation présente une valeur sensiblement constante en fonction de la température, tandis que la longueur du canal est choisie pour obtenir une valeur souhaitée de ce courant de limitation.

9. Procédé de fabrication d'un composant dipôle selon la revendication 8, dans un substrat (11) du premier type de conductivité, caractérisé en ce qu'il comprend les étapes suivantes, réalisées dans la face avant du substrat :

former au moyen d'un premier masque des caissons (21, 22) du deuxième type de conductivité ;
former dans chacun de ces caissons, en utilisant le premier masque et un masque supplémentaire (29) des régions annulaires (34) du deuxième type de conductivité ;
implanter un dopant du premier type de conductivité en utilisant un troisième masque laissant découverte la partie périphérique de chacun des caissons (21-22) entre l'extérieur de ce caisson et la région annulaire (34) pour inverser le type de conductivité de cette région périphérique ;
faire croître une couche d'oxyde ayant une épaisseur d'isolement de grille choisie ;
ouvrir les couches d'oxyde au-dessus des parties centrales de chaque caisson, y compris la partie intérieure de chaque région annulaire ; et
former une métallisation (44) sur cette face avant ; et en ce qu'il comprend en outre l'étape consistant à former une métallisation sur la face arrière.

10. Procédé selon la revendication 9, caractérisé en ce que le troisième masque comprend des portions (14-1) protégeant des zones du substrat intemédiaires entre des caissons voisins.

**Claims**

1. A two-terminal current clipping component including a depleted MOS or IGBT transistor of the double diffused vertical (VDMOS) type, characterized in that the source metallization and gate metallization of said transistor are made of a single metallization, and in that the doping level of the depleted channel region is selected so that the limiting current has a substantially constant value as a function of the temperature.

2. A two-terminal current limiting component according to claim 1, including:

a substrate (11) of a first conductivity type;
separated wells (21, 22) of the second conductivity type, formed in the upper surface of the substrate;
a first annular region (34) of the first conductivity type having a high doping level in each well;

a second, shallow, annular region (38) of the first conductivity type having a low doping level between the outer periphery of each first annular region and the periphery of each well;

an insulating layer (42) over the second annular region, the portion of the first annular region adjacent to the second annular region, and the upper surface portions of the substrate between the wells, and constituting a gate insulator;

a first metallization (44) coating the upper surface of the component and constituting said gate and source metallization; and

a second metallization coating the lower surface of the component.

3. The two-terminal component of claim 2, characterized in that it further comprises a first highly doped peripheral region (36) of the first conductivity type and a second peripheral inner region (24), separated from the first peripheral region by an area of the substrate, said second peripheral region being of the second conductivity type and having a low doping level.

4. The two-terminal component of claim 2, characterized in that it includes a central highly doped region (26) of the second conductivity type.

5. The two-terminal component of claim 2, characterized in that the central region (21) of each well is more highly doped than the peripheral portion (22).

6. The two-terminal component of any of claims 2 to 5, characterized in that it includes on the lower surface of the substrate the same wells, regions and layer, thereby constituting a bidirectional current limiting component.

7. The two-terminal component of any of claims 1 to 6, characterized in that it is solder-bonded between two heat sinks.

8. A method for manufacturing a two-terminal component according to claim 1, characterized in that the channel region results from an implantation of the first conductivity type formed in a peripheral region of the second conductivity type so that the doping level of the resulting channel is of the first conductivity type and so that the limiting current has a substantially constant value as a function of the temperature whereas the length of the channel is selected to obtain a desired value for said limiting current.

9. The method for manufacturing a two-terminal component according to claim 8, in a substrate (11) of the first conductivity type, characterized in that it includes the following steps implemented in the front surface of the substrate:

forming, through a first mask, wells (21, 22) of the second conductivity type;

forming, in each of said wells, by using the first mask and an additional mask (29), annular regions (34) of the second conductivity type;

implanting a dopant of the first conductivity type by using a third mask that does not cover the peripheral portion of each well (21-22) between the outer portion of said well, and the annular region (34), to invert the conductivity type of said peripheral region;

growing an oxide layer having a predetermined thickness for gate insulation;

etching the oxide layers over the central portions of each well, including the inner portion of each annular region; and

forming a metallization (44) on said front surface and in that it further comprises the step of forming a metallization on the rear surface.

10. The method of claim 9, characterized in that said third mask includes portions (14-1) for protecting intermediate areas of the substrate between adjacent wells.

## Patentansprüche

1. Strombegrenzendes Bauelement mit zwei Anschlüssen, das einen Verarmungs-MOS oder IGBT-Transistor vom doppelt diffundierten vertikalen Typ (VDMOS) aufweist, dadurch gekennzeichnet, daß die Source-Metallisierung und die Gate-Metallisierung des Transistors aus einer einzigen Metallisierung bestehen und daß das Dotierniveau der Verarmungskanalregion so gewählt ist, daß der Begrenzungsstrom einen über der Temperatur im wesentlichen konstanten Wert aufweist.

2. Strombegrenzendes Bauelement mit zwei Anschlüssen nach Anspruch 1, umfassend:

- ein Substrat (11) eines ersten Leitfähigkeitstyps;
- getrennte Wannen (21, 22) eines zweiten Leitfähigkeitstyps, die auf der Oberseite des Substrats gebildet sind;
- eine erste, ringförmige Region (34) des ersten Leitfähigkeitstyps mit einem hohen Dotierniveau in jeder Wanne;
- eine zweite, ringförmige Region (38), die einen Kanal des ersten Leitfähigkeitstyps mit einem geringen Dotierniveau und geringer Tiefe aufweist, zwischen dem äußeren Randbereich jeder ersten ringförmigen Region und dem Randbereich jeder Wanne;
- eine isolierende Schicht (42) über der zweiten ringförmigen Region, wobei der Abschnitt der ersten ringförmigen Region der zweiten ringförmigen Region benachbart ist, und über dem freiliegenden Substrat zwischen den Wannen, die eine Gate-Isolation bildet;
- eine erste Metallisierung (44), die die Oberseite des Bauelements bedeckt und die Gate- und Source-Metallisierung bildet; und
- eine zweite Metallisierung, die die Unterseite des Bauelements bedeckt.

3. Bauelement mit zwei Anschlüssen nach Anspruch 2, dadurch gekennzeichnet, daß es weiterhin eine erste hochdotierte Randbereichsregion (36) eines ersten Leitfähigkeitstyps und eine zweite innere Randbereichsregion (24), die von der ersten Randbereichsregion durch einen Substratbereich getrennt ist, umfaßt, wobei die zweite Randbereichsregion den zweiten Leitfähigkeitstyp und ein geringes Dotierniveau aufweist.

4. Bauelement mit zwei Anschlüssen nach Anspruch 2, dadurch gekennzeichnet, daß es eine zentrale hochdotierte Region (26) des zweiten Leitfähigkeitstyps aufweist.

5. Bauelement mit zwei Anschlüssen nach Anspruch 2, dadurch gekennzeichnet, daß die zentrale Region (21) jeder getrennten Wanne höher dotiert ist als der Randbereichsabschnitt (22).

6. Bauelement mit zwei Anschlüssen nach einem der Ansprüche 2 bis 5, dadurch gekennzeichnet, daß es auf der Unterseite des Substrats die gleichen Wannen, Regionen und Schichten aufweist, wodurch ein bidirektionales strombegrenzendes Bauelement gebildet wird.

7. Bauelement mit zwei Anschlüssen nach einem der Ansprüche 1 bis 6, dadurch gekennzeichnet, daß es zwischen zwei Wärmeableitern mit einer Lötverbindung angebracht ist.

8. Verfahren zum Herstellen eines Bauelements mit zwei Anschlüssen nach Anspruch 1, dadurch gekennzeichnet, daß die Kanalregion aus einer Implantation des ersten Leitfähigkeitstyps, die in einer Randbereichsregion des zweiten Leitfähigkeitstyps gebildet wird, stammt, so daß das Dotierniveau der resultierenden Kanalregion den ersten Leitfähigkeitstyp aufweist und so daß der Begrenzungsstrom einen über der Temperatur im wesentlichen konstanten Wert aufweist, wobei die Kanallänge so ausgewählt wird, daß ein gewünschter Wert für diesen Begrenzungsstrom erhalten wird.

9. Verfahren zur Herstellung eines Bauelements mit zwei Anschlüssen nach Anspruch 8 in einem Substrat (11) des ersten Leitfähigkeitstyps, dadurch gekennzeichnet, daß es die folgenden Schritte für die Vorderseite des Substrats aufweist:

- Bilden von Wannen (21, 22) des zweiten Leitfähigkeitstyps durch eine erste Maske;
- Bilden von ringförmigen Regionen (34) des zweiten Leitfähigkeitstyps in jeder der Wannen, indem die erste Maske und eine zusätzliche Maske (29) verwendet wird;
- Implantieren eines Dotierstoffes des ersten Leitfähigkeitstyps, indem eine dritte Maske verwendet wird, die den Randbereichsabschnitt jeder Wanne (21-22) zwischen dem äußeren Abschnitt der Wanne und der ringförmigen Region (34) unbedeckt läßt, um den Leitfähigkeitstyp der Randbereichsregion zu invertieren;
- Aufwachsen einer Oxidschicht mit einer vorbestimmten Dicke für die Gate-Isolation;
- Öffnen der Oxidschichten über zentralen Abschnitten jeder Wanne, die den inneren Abschnitt jeder ringförmigen Region umfassen; und
- Bilden einer Metallisierung (44) auf dieser Vorderseite;

und daß es weiterhin das Ausbilden einer Metallisierung auf der Rückseite umfaßt.

**10.** Verfahren nach Anspruch 9, dadurch gekennzeichnet, daß die dritte Maske Abschnitte (14-1) aufweist, um Substratbereiche zwischen benachbarten Wannen zu schützen.

Fig 1

Fig 2

Fig 3

16

P+

15

14

N

11

12    N+

Fig 4A

17 P

14

11    N

Fig 4B

P−    20
18

14

11    N

Fig 4C

20

14

11    P−    P    P+    P    P+ P    P+

24    21    22    26

Fig 4D

30    30    N
29
28

14    x x x x x x    x x    x x    x x x x x

Fig 4E

32

14    N+

36    N    21    22    34

Fig 4F

36
14    14−1    N    14−1    14    32
32
14

11    21    22    34

Fig 4G

Fig 4H

Fig 4I

Fig 5

Fig 6

Fig 7

Fig 8